(19)

Europäisches
Patentamt
European
Patent Office
Office européen
des brevets

(11) **EP 3 275 836 A1**

(12) **EUROPEAN PATENT APPLICATION**
published in accordance with Art. 153(4) EPC

(43) Date of publication:
**31.01.2018 Bulletin 2018/05**

(51) Int Cl.:
*C01B 31/02* [(0000.00)]   *B01J 23/745* [(2006.01)]
*B01J 35/02* [(2006.01)]   *B01J 37/34* [(2006.01)]
*C01B 3/04* [(2006.01)]

(21) Application number: 16772687.6

(22) Date of filing: **25.03.2016**

(86) International application number:
**PCT/JP2016/059776**

(87) International publication number:
**WO 2016/158806 (06.10.2016 Gazette 2016/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **27.03.2015 JP 2015066945**

(71) Applicants:
• **Fuji Chemical Industry Co., Ltd.
Nakaniikawa-gun, Toyama 930-0397 (JP)**
• **Kwansei Gakuin Educational Foundation
Nishinomiya-shi, Hyogo 662-8501 (JP)**

(72) Inventors:
• **KINOSHITA, Isamu
Osaka-shi
Osaka 558-8585 (JP)**

• **HASHIMOTO, Hideki
Sanda-shi
Hyogo 669-1337 (JP)**
• **ISOBE, Kiyoshi
Sanda-shi
Hyogo 669-1337 (JP)**
• **SERA, Yoshihiko
Sanda-shi
Hyogo 669-1337 (JP)**
• **YAMASHITA, Eiji
Nakaniikawa-gun
Toyama 930-0355 (JP)**
• **HORIBE, Tomoko
Nakaniikawa-gun
Toyama 930-0355 (JP)**

(74) Representative: **Hoffmann Eitle
Patent- und Rechtsanwälte PartmbB
Arabellastraße 30
81925 München (DE)**

(54) **NOVEL COMPOSITE OF IRON COMPOUND AND GRAPHENE OXIDE**

(57)    Provided is a novel composite of an iron compound and a graphene oxide which is extremely useful as a photocatalyst or an active ingredient of an electrode. In this composite of an iron compound and graphene oxide, iron compound particles are supported on the graphene oxide.

**EP 3 275 836 A1**

**Description**

TECHNICAL FIELD

The present invention relates to a composite comprising an iron compound and a graphene oxide, a method for producing the composite, and a use of the composite, particularly a use of the composite as a photocatalyst for production (generation) of hydrogen from water or the like and as an electrode to be used in decomposition reaction of water.

BACKGROUND ART

A technology has been heretofore known in which hydrogen is generated from water, an alcohol or the like using photo energy from sunlight etc., and in such technology, a photocatalyst is used (see, for example, Patent Document 1). As the photocatalyst, metal oxide semiconductors such as titanium oxide using platinum or the like as a co-catalyst, and metal complexes using platinum, ruthenium, cobalt, nickel or the like have been known, and technology for improving hydrogen generation efficiency using these materials has been extensively studied.

As the composite comprising graphene oxide and iron, for example, the following composites have been known. It has been known that a composite by forming iron oxide nanoparticles on the surface of graphene oxide reduced by stroboscopic light is used for a lithium ion electrode (Non-Patent Document 1). An iron carbon composite has been known which is obtained by drying and heat-treating iron nitrate and a gel of sodium carboxymethyl-cellulose and in which the average particle size of iron oxide is in the range of 2 to 100 nm, and the iron/carbon ratio is 0.01 to 0.5 (Patent Document 2). An iron carbon composite has been known in which iron oxide having an average particle size of 2 to 100 nm is dispersed in amorphous carbon, and the iron/carbon ratio is in the range of 0.01 to 0.5, the iron carbon composite having magnetism (Patent Document 3). A composite comprising an iron oxide and a graphene oxide was synthesized by mixing iron oxide having magnetism with an aqueous solution of graphene oxide, and drying the mixture, and the resultant composite was used as a biocompatibility enhancement reagent (Non-Patent Document 2).

It has been known that graphene oxide supporting iron oxide having magnetism is used as a photo-hydrogen generation electrode (Non-Patent Document 3).

PRIOR ART DOCUMENTS

PATENT DOCUMENTS

Patent Document 1: Japanese Patent Laid-open Publication No. 2012-245469
Patent Document 2: Japanese Patent Laid-open Publication No. 2013-35743
Patent Document 3: Japanese Patent Laid-open Publication No. 2014-69973

NON-PATENT DOCUMENTS

Non-Patent Document 1: Chemical Society of Japan, Lecture Proceedings, 95, 3, 649, 2015
Non-Patent Document 2: Nanoscale Research Letters, 9, 656, 2014
Non-Patent Document 3: Advanced Materials, 25, 3820-3839, 2013

SUMMARY OF THE INVENTION

PROBLEMS TO BE SOLVED BY THE INVENTION

An object of the present invention is to provide a novel composite comprising an iron compound and a graphene oxide which is extremely useful as a photocatalyst or an active component of an electrode. Specifically, the object of the present invention is to provide a photocatalyst which can be used for a longer time period, can be prepared with using a material having a less environmental load, and is useful for generating hydrogen from water or the like by means of natural light; a hydrogen generation equipment using the catalyst; and an electrode which is used for decomposition reaction of water. Another object of the present invention is to provide a method for producing a novel composite comprising an iron compound and a graphene oxide; and a method for producing hydrogen from water or the like by using such composite.

## MEANS FOR SOLVING THE PROBLEM

The present inventors have found that when a novel composite comprising an iron compound and a graphene oxide, in which the iron compound particles having a particle size of 0.1 to 10 nm are firmly dispersed and supported on graphene oxide, having an epoxy group is used as a photocatalyst, very high efficiency on hydrogen generation from water or the like is attained. In the photocatalyst, a cheaper metal is used, and therefore the production cost of hydrogen can be reduced. Further, the present inventors have found that such composite comprising iron compound and graphene oxide is suitably produced by a simple method in which in an inert solvent, an iron compound and a graphene oxide are irradiated with a light including ultraviolet and visible lights. The present invention has been completed by further conducting studies on the basis of those findings.

## ADVANTAGES OF THE INVENTION

The present invention provides a photocatalyst including a composite comprising an iron compound which exists in a large amount in the earth crust, and is thus stably supplied and has high environmental safety, and graphene oxide. The photocatalyst of the present invention is inexpensive, has high hydrogen generation efficiency, is easily recovered and reused, has extremely reduced pollution on the environment, and is capable of considerably reducing the production cost of hydrogen. The present invention can also provide a novel composite comprising an iron compound and a graphene oxide which is extremely useful as the photocatalyst, a method for producing the composite, and a use of the composite, particularly as a photocatalyst for production (generation) of hydrogen from water or the like and as a catalyst to be used in decomposition reaction of water. The present invention can also provide a method for producing (generating) hydrogen from water or the like by using the composite comprising iron compound and graphene oxide.

The present invention provides the following embodiments of the inventions.

Item 1. A particulate composite comprising an iron compound and a graphene oxide, wherein

(1) the primary particles' size of the particulate composite is in the range of 0.1 to 100 $\mu$m,
(2) the particle size of the iron compound is in the range of 0.1 to 10 nm,
(3) the content of iron in the composite is in the range of 0.1 to 50% by mass,
(4) an absorption originating from an O-H group, an absorption originating from a C=O group, and an absorption around 701 cm$^{-1}$ originating from an Fe-O group are substantially absent, and an absorption originating from a C-O group is present in an infrared absorption spectrum of such composite, and
(5) the iron compound is supported on the graphene oxide.

Item 2. The composite according to the Item 1, wherein the iron compound is $Fe_3O_4$, $Fe_2O_3$ or a mixture thereof.
Item 3. The composite according to the Item 1 or 2, wherein the particle size of the iron compound is in the range of 0.5 to 5 nm.
Item 4. The composite according to any one of the Items 1 to 3, wherein the content of iron in the composite is in the range of 0.5 to 40% by mass.
Item 5. The composite according to any one of the Items 1 to 4, which has substantially no signal above $2\theta = 30°$ in a powder X-Ray diffraction measurement.
Item 6. The composite according to any one of the Items 1 to 4, wherein the graphene keeps supporting the iron compound after an irradiation with white light in an aqueous solution at pH 2, and the graphene oxide keeps supporting the iron compound after an irradiation with white light in an aqueous solution at pH 14.
Item 7. A method for producing a composite comprising an iron compound and a graphene oxide, the method including the step of suspending the iron compound and the graphene oxide as raw materials in an inert solvent, and irradiating the resultant suspension with a light including ultraviolet and visible lights.
Item 8. The method according to the Item 7, wherein the iron compound as a raw material is at least one of a salt of iron and an inorganic acid, a salt of iron and carboxylic acid, a salt of iron and sulfonic acid, iron hydroxide, phenol iron, iron double salts, and iron complexes.
Item 9. The method according to the Item 7 or 8, wherein the ultraviolet and the visible lights have a wavelength in the range of 100 nm to 800 nm.
Item 10. The method according to any one of the Items 7 to 9, wherein the time of irradiation with a light including ultraviolet and visible lights is in the range of 1 minute to 24 hours.
Item 11. A photocatalyst including the composite comprising iron compound and graphene oxide according to any one of the Items 1 to 6.

Item 12. A method for producing hydrogen, wherein water, an alcohol or a mixture thereof is, with mixing a photosensitizer and/or an electron donor additionally as necessary, irradiated with light in the presence of the composite comprising iron compound and graphene oxide according to any one of the Items 1 to 6.

Item 13. The method according to the Item 12, wherein the alcohol is ethanol.

Item 14. The method according to the Item 12 or 13, wherein the light is a sunlight or a white LED light.

Item 15. A hydrogen production equipment including the composite comprising iron compound and graphene oxide according to any one of the Items 1 to 6 as a hydrogen generation catalyst.

BRIEF DESCRIPTION OF THE DRAWINGS

Fig. 1 shows data showing the results of MALDI and FT-ICR-MS analysis of a graphene oxide obtained in Example 1(1).

Fig. 2 shows an ultraviolet and visible absorption spectrum of the graphene oxide obtained in Example 1(1).

Fig. 3 shows data showing the results of powder X-ray diffraction measurement of the graphene oxide obtained in Example 1(1).

Fig. 4 shows a schematic view of an equipment used in Example 1(2) for synthesizing a composite of an iron compound and a graphene oxide.

Fig. 5 shows data showing the results of X-ray fluorescence analysis of a composite comprising an iron compound and a graphene oxide which is obtained in Example 1(2).

Fig. 6 shows infrared absorption spectra (IR: ATR method) of the graphene oxide obtained in Example 1(1) and the composite comprising iron compound and graphene oxide which is obtained in Example 1(2).

Fig. 7 shows data showing the results of X-ray diffraction measurement of the composite comprising iron compound and graphene oxide which is obtained in Example 1(2).

Fig. 8 shows a photograph of an equipment used in Example 3 for synthesizing a composite comprising an iron compound and a graphene oxide.

Fig. 9 shows data showing the results of X-ray photoelectron spectroscopic (XPS) measurement of the surface of the composite comprising iron compound and graphene oxide which is obtained in Example 3.

Fig. 10 shows a mapping image of iron atoms which is obtained by observing the surface of the composite comprising iron compound and graphene oxide which is obtained in Example 3, by scanning electron microscopy/energy dispersive spectroscopy (SEM/EDX).

Fig. 11 shows a mapping image of oxygen atoms which is obtained by observing the surface of the composite comprising iron compound and graphene oxide which is obtained in Example 3, by scanning electron microscopy/energy dispersive spectroscopy (SEM/EDX).

Fig. 12 shows a mapping image of carbon atoms which is obtained by observing the surface of the composite comprising iron compound and graphene oxide which is obtained in Example 3, by scanning electron microscopy/energy dispersive spectroscopy (SEM/EDX).

Fig. 13 shows a mapping image of iron atoms which is obtained by observing the surface of the composite comprising iron compound and graphene oxide which is obtained in Example 3, by transmission electron microscopy/energy dispersive spectroscopy (TEM/EDX).

Fig. 14 shows a mapping image of oxygen atoms which is obtained by observing the surface of the composite comprising iron compound and graphene oxide which is obtained in Example 3, by transmission electron microscopy/energy dispersive spectroscopy (TEM/EDX).

Fig. 15 shows a mapping image of carbon atoms which is obtained by observing the surface of the composite comprising iron compound and graphene oxide which is obtained in Example 3, by transmission electron microscopy/energy dispersive spectroscopy (TEM/EDX).

Fig. 16 shows an image obtained by observing the surface of the composite comprising iron compound and graphene oxide, which is obtained in Example 3, using a transmission electron microscopy (TEM).

Fig. 17 shows an image obtained by observing the surface of the composite comprising iron compound and graphene oxide, which is obtained in Example 3, using scanning electron microscopy.

Fig. 18 shows an image obtained by observing the surface of the composite comprising iron compound and graphene oxide, which is obtained in Example 4, using scanning electron microscopy.

Fig. 19 shows a photograph of an equipment used in Example 5 for producing (generating) hydrogen using a composite comprising an iron compound and a graphene oxide as a photocatalyst.

Fig. 20 shows a graph obtained by plotting the light irradiation time and the total amount of generated hydrogen in Example 5.

Fig. 21 shows a graph obtained by plotting the light irradiation time and the total amount of generated hydrogen in Example 6.
Fig. 22 shows a graph obtained by plotting the light irradiation time and the total amount of generated hydrogen in Example 7.
Fig. 23 shows a graph obtained by plotting the light irradiation time and the total amount of generated hydrogen in Example 8.
Fig. 24 shows a cyclic voltammogram in Example 9(2).

EMBODIMENT OF THE INVENTION

1. Composite comprising Iron Compound and Graphene Oxide

A composite comprising an iron compound and a graphene oxide according to the present invention has a characteristic that nano-sized particulate iron compound(s) are uniformly and firmly dispersed and supported on powdered graphene oxide.

The composite comprising iron compound and graphene oxide according to the present invention can be distinguished from the iron-oxide graphene composites shown in the foregoing documents on the basis of, for example, the following properties: (1) oxygen substantially forms an epoxy group rather than a hydroxyl group or a carbonyl group as a bond state of carbon and oxygen in the graphene oxide; (2) iron compound particles having a particle size of 0.1 to 10 nm are uniformly dispersed and supported on the graphene oxide; (3) graphene oxide and iron compound are firmly supported and (4) the iron compound or the composite thereof does not show magnetism. It has not been known that the composite comprising iron compound and graphene oxide which has the properties shown in the above (1) to (4) is significantly useful as a photocatalyst.

The composite according to the present invention forms a particle state wherein primary particles of the composite comprising a scale-like and/or plate-like iron compound and graphene oxide are aggregated. The primary particle size of the composite according to the present invention may be in the range of 0.1 to 100 $\mu$m, and is preferably in the range of 0.5 to 80 $\mu$m, most preferably 2 to 40 $\mu$m. The particle size is determined from a scanning electron microscope (SEM) photograph. The primary particle size of the composite according to the present invention is similar to the size of graphene oxide or graphene as a raw material, and the molecular weight of the composite will be described later in the section of a production method of the composite.

The iron compound in the composite according to the present invention is zero-valent iron, divalent iron, trivalent iron, or a mixture of one or more thereof. The iron compound is preferably divalent iron, trivalent iron, or mixture of one or more thereof, more preferably an oxide of divalent iron, an oxide of trivalent iron, or a mixture of one or more thereof, and most preferably $Fe_2O_3$, $Fe_3O_4$, or a mixture thereof.

The content of iron in the composite according to the present invention may be, for example, in the range of 0.1 to 50% by mass and is preferably in the range 0.5 to 40% by mass, more preferably 2 to 30% by mass, especially preferably 5 to 20% by mass to the total mass of the composite of the present invention.

The particle size of the iron compound in the composite according to the present invention may be, for example, in the range of 0.1 to 10 nm, and is preferably in the range of 0.5 to 5 nm, most preferably 1 to 4 nm. The particle size can be measured using a transmission electron microscope (TEM) as described later.

In the composite according to the present invention, oxygen forms graphene oxide mainly as an epoxy group. This can be verified by confirming that in an IR spectrum of the composite comprising iron compound and graphene oxide, an absorption (absorption around 1072 cm$^{-1}$) originating from a C-O group (epoxy group) is present, and absorptions (absorptions in a range of 3000 cm$^{-1}$ to 3800 cm$^{-1}$ and around 1382 cm$^{-1}$) originating from an O-H group (hydroxyl group), an absorption (absorption around 1614 cm$^{-1}$) originating from a C=O group (carbonyl group) and an absorption (absorption around 701 cm$^{-1}$) originating from a Fe-O group (bond of iron and oxygen) are substantially absent. A part of the composite may contain hydroxyl groups and carbonyl groups. Here, the term "substantially absent" of the present inventions means that the relative value of the peak heights of the absorptions originating from the above groups (carbonyl group and Fe-O group) to the peak height of the absorption originating from the C-O group (epoxy group) is 0.1 or less.

The composite according to the present invention does not show magnetism, and the iron compound(s) are firmly dispersed and supported on the graphene oxide. No magnetism can be verified by confirming that the composite comprising iron compound and graphene oxide is not attracted to a magnet as shown in the examples described later.

The bond between the iron compound and graphene oxide in the composite according to the present invention is stronger than that in a previously known iron-graphene oxide composite supporting its iron compound on the surface of its graphene oxide. Thus, when the composite according to the present invention is used as a catalyst, much higher reusability is attained. How the bond between the iron compound and graphene oxide of the present invention is strong is demonstrated by showing that even when the composite is irradiated with light (e.g. white LED: OSW4XMEC1E, optosupply, irradiation time: 8 days) in an acidic aqueous solution at pH 2 or an alkaline aqueous solution at pH 14, iron compound particles supported on graphene oxide are not aggregated (e.g. even when after irradiation with light, a Nd-Fe-B based magnet (NIHON JISYAKU KOGYO Co., Ltd, neodymium magnet $\phi$ 10 mm x 2 mm) is brought into contact with the outer wall of a test tube with the composite dispersed therein, the composite is not attracted to the magnet and to the test tube wall), and are firmly fixed to graphene oxide.

2. Method for Producing Composite comprising Iron Compound and Graphene Oxide

The composite comprising iron compound and graphene oxide according to the present invention is produced using an equipment which includes a hard glass vessel including a nitrogen supply line with a bubbler, a reaction liquid back stopper, a stirrer, and an inert gas inlet and outlet and which includes a mercury lamp with a quartz jacket (USHIO 450W high-pressure mercury lamp) and a water bath with a circulation-type cooling system (around 30°C) at the outer part, or an equipment which includes a hard glass reaction vessel including a stirrer, an inert gas inlet and outlet, and a water-flow cooler as necessary and which includes a light irradiator covered with a cooling jacket of quartz glass (light source: 100 W high-pressure mercury lamp; SEN LIGHTS Co., Ltd.; HL100CH-4) at the inner part. Preferably, production of the composite is performed by irradiating the iron compound and graphene oxide as raw materials with ultraviolet and visible lights under an atmosphere of an inert gas (e.g. nitrogen gas, argon gas or the like).

The iron compound as a raw material which is used in this production process is a zero-valent, divalent or trivalent iron compound, and may be, for example, a salt of iron and an inorganic acid, such as iron chloride, iron bromide, iron nitrate, iron sulfate, iron phosphate or iron perchlorate; a salt of iron and a carboxylic acid, such as iron formate, iron acetate, iron fluoroacetate, iron propionate, iron oxalate, iron fumarate, iron citrate, iron tartrate, iron stearate or iron benzoate; or a salt of iron and a sulfonic acid, such as iron methanesulfonate, iron trifluoromethanesulfonate, iron ethanesulfonate, iron benzenesulfonate or iron para-sulfonate; iron hydroxide; phenol iron; an iron double salt such as sodium iron hexacyanate, potassium iron hexacyanate, ammonium iron hexacyanate or sodium iron ethylenediaminetetraacetate; or an iron complex such as an acetylacetonate iron complex or an iron-carbonyl compound. The iron compound is preferably iron chloride, iron bromide, iron nitrate, iron sulfate, iron phosphate, a salt of iron and a carboxylic acid, iron hydroxide, phenol iron, an acetylacetonate iron complex or an iron carbonyl compound, more preferably iron chloride, iron acetate, iron hydroxide, an acetylacetonate iron complex or an iron-carbonyl compound, and most preferably iron chloride, iron acetate or an iron-carbonyl compound.

The graphene oxide to be used may be, for example, a commercially available product, or one produced by oxidizing graphite or graphene, and is preferably one produced by oxidizing graphite (e.g. one produced by oxidizing graphite using sulfuric acid, potassium permanganate or the like). When graphite is oxidized using sulfuric acid, the graphene oxide contains a very small amount of sulfur, and a composite comprising an iron compound and a graphene oxide which is produced using the graphene oxide usually contains a very small amount of sulfur. As the graphene oxide, for example, one commercially available as a graphene oxide powder, graphene oxide, reductive graphene oxide or a high-specific-surface-area graphene nanopowder can be used, and specifically, one commercially available from Sigma-Aldrich Co. LLC etc. can be used.

As the graphite to be used for production of graphene oxide, any graphite may be used as long as it is suitable for the composite according to the present invention. As for the shape of graphite, for example, spherical graphite, granular graphite, scaly graphite, scale-like graphite and powdered graphite can be used, and scaly graphite and scale-like graphite are preferably used from the viewpoint of ease of supporting the iron compound on the graphene oxide, and catalytic activity. Specifically, commercially available graphite such as powdered graphite manufactured by Nacalai Tesque, or a high-specific-surface-area graphene nanopowder from EM Japan, Ltd. can be used. The primary particle size of the graphite is in the range of 0.1 to 100 $\mu$m, preferably 0.5 to 80 $\mu$m, and most preferably 2 to 40 $\mu$m.

The composition formula of the graphene oxide is, for example, $[C_xO_yH_z]_k$. Here, x is 5 to 12, y is 2 to 8, z is 2 to 10, and k is 8 to 15. Preferably, x is 6 to 10, y is 3 to 6, z is 2 to 5, and k is 10 to 13.

The molecular weight of the graphene oxide is, for example, 500 to 5000, preferably 800 to 4000, more preferably 1500 to 3000, and most preferably 2000 to 2500.

The mixing ratio of an iron compound and graphene oxide may be set in a manner that the composite comprising iron compound and graphene oxide has a predetermined or preferred content of the iron compound.

The wavelength of each of ultraviolet light and visible light to be used may be in the range of 100 nm to 800 nm, and is preferably in the range of 180 nm to 600 nm, more preferably 260 nm to 600 nm.

The inert solvent to be used in this invention is not particularly limited as long as it is not involved in the reaction, and the inert solvent may be, for example, an ether such as diethyl ether, tetrahydrofuran or dioxane; an alcohol such as methanol, ethanol or isopropyl alcohol; an ester such as ethyl acetate or propyl acetate; an amide such as dimethyl formamide or dimethyl acetamide; a sulfoxide such as dimethyl sulfoxide; water; or a mixed solvent thereof. The inert solvent is preferably an ether, an alcohol, an amide, water, or a mixed solvent thereof, most preferably tetrahydrofuran, ethanol, dimethyl formamide, water, or a mixed solvent of one or more thereof.

The reaction temperature varies depending on the raw material, the wavelengths of ultraviolet and visible lights, and so on, but is usually 0°C to 50°C, preferably 10°C to 30°C, and most preferably 20°C to 30°C.

The reaction time varies depending on the using raw materials, the wavelengths of ultraviolet and visible lights, the reaction temperature, and so on, but is usually in the range of 1 minute to 24 hours, preferably 10 minutes to 10 hours, and most preferably 30 minutes to 5 hours.

After the reaction is completed, the composite comprising iron compound and graphene oxide as a specified substance is isolated from a reaction mixture by a usual method (e.g. the reaction mixture is filtered, and the resulting solid is washed, and dried to isolate a specified substance in the form of a powder).

3. Uses of Composite comprising Iron Compound and Graphene Oxide

(1) Use as Photocatalyst

By using as a photocatalyst the composite comprising iron compound and graphene oxide according to the present invention, hydrogen can be produced from water or the like.

An equipment to be used for production of hydrogen includes a hard glass vessel including a gas outlet capable of continuously discharging generated hydrogen to outside, a stirrer and a thermometer, and includes a light irradiator inside or outside the vessel.

The composite comprising iron compound and graphene oxide according to the present invention, or a material holding the composite (e.g. a glass or plastic transparent plate with the composite held thereon using a resin-based adhesive or the like), water or the like as a raw material for production of hydrogen, and a reaction promotor (e.g. photosensitizer, electron donor or the like) is added in the vessel, and the resulting suspension is irradiated with light, whereby hydrogen can be produced.

The water or the like as a raw material for production of hydrogen may be, for example, water, an alcohol such as methanol, ethanol or propanol, a mixture thereof, and is preferably water, ethanol or a mixture thereof, especially preferably water. The water may be, for example, tap water, distilled water, ion-exchanged water, pure water or industrially available water, and is preferably tap water, distilled water or industrially available water.

The light to be applied may be, for example, sunlight, white LED light, fluorescent lamp light or high-pressure mercury lamp light, and is preferably sunlight or white LED light.

The using ratio of the photocatalyst to water or the like as a raw material for the production of hydrogen may be, for example, in the range of 0.0001 to 5% by mass, and is preferably in the range of 0.001 to 1% by mass, most preferably 0.01 to 0.1% by mass.

The photosensitizer to be used as a reaction promotor is a known photosensitizer, and may be, for example, an aromatic hydrocarbon-based dye (e.g. coumarin, fluorescein, dibromofluorescein, eosine Y, eosine B, erythrosine B, rhodamine B, rose bengal, crystal violet, malachite green, auramine O, acridine orange, brilliant cresyl blue, neutral red, thionine, methylene blue, orange II, indigo, alizarine, pinacyanol, berberine, tetracycline, purpurin or thiazole orange, a pyrylium salt-based dye (e.g. pyrylium, thiopyrylium or selenopyrylium), a cyanine-based dye, an oxonol-based dye, a merocyanine-based dye or a triallylcarbonium-based dye); a fullerene derivative (e.g. hydroxylated fullerene, aminobutyric acid fullerene, bis-malonic acid fullerene or bis-malonic acid ethyl fullerene); porphyrin, a phthalocyanine analogue (e.g. photofrin, laserphyrin, visudyne, hematoporphyrin, deuteroporphyrin IX-2,4-di-acrylic acid, deuteroporphyrin IX-2,4-di-sulfonic acid, 2,4-diacetyldeuteroporphyrin IX, TSPP, phthalocyaninetetracarboxylic acid, phthalocyaninedisulfonic acid, phthalocyaninetetrasulfonic acid, or a complex thereof with a metal such as zinc, copper, cadmium, cobalt, magnesium, aluminum, platinum, palladium, gallium, germanium, silica or tin); or a metal complex-based dye (e.g. ruthenium-bipyridine complex, ruthenium- phenanthroline complex, ruthenium-bipyrazine complex, ruthenium-4,7-diphenyl phenanthroline complex, ruthenium-diphenyl-phenanthroline-4,7-disulfonate complex, platinum-dipyridylamine complex or palladium-dipyridylamine complex). The photosensitizer is preferably fluorescein or dibromofluorescein, most preferably fluorescein. The photosensitizers may be used singly, or used in combination of two or more thereof.

The use amount of the photosensitizer may be, for example, 0.1 to 100 parts by mass, and is preferably 1 to 10 parts by mass based on 1 part by mass of the photocatalyst.

The electron donor is a compound capable of donating electrons to the photosensitizer, and may be, for example, triethylamine, triethanolamine, ethylenediaminetetraacetic acid (EDTA) or ascorbic acid. The electron donor is preferably triethylamine or triethanolamine. The electron donors may be used singly, or used in combination of two or more thereof.

The use amount of the electron donor may be, for example, 10 to 1000 parts by mass, and is preferably 100 to 750 parts by mass based on 1 part by mass of the photocatalyst.

The reaction temperature may be, for example, in the range of 0 to 60°C, and is preferably in the range of 20 to 50°C. Since during irradiation of the photocatalyst with light, hydrogen is continuously produced, the photocatalyst may be irradiated with light for a necessary time during which hydrogen is produced.

Since the resulting hydrogen can be continuously discharged to outside through the gas outlet, the hydrogen can be enclosed in a cylinder or the like as necessary during storage, transportation or the like.

(2) Use as Active Component in Electrode

An electrode including the composite comprising iron compound and graphene oxide according to the present invention can be produced by a usual method (e.g. the composite and a carbon paste are mixed at a weight ratio of 1 : 100, the mixture is packed into a recess of a carbon paste electrode, and the electrode is rubbed against a medical packing paper placed on a flat stand, whereby an electrode can be produced).

The electrode according to the present invention may be formed substantially from only the composite comprising iron compound and graphene oxide according to the present invention (the electrode may contain the composite substantially as an active component), or the surface of the electrode may be formed from the composite according to the present invention while the inner part of the electrode is formed from other material such as a metal.

Further, the electrode according to the present invention can be made similarly in size, shape and the like to a known (hydrogen generation) electrode, and can be used as an alternative to a known electrode to be used for electrolysis of water.

Further, the (hydrogen generation) electrode according to the present invention can be produced at much lower cost, and exhibits higher hydrogen generation efficiency, so that the production cost of hydrogen can be considerably reduced.

EXAMPLES

Hereinafter, the present invention will be described more in detail by way of examples, but the present invention is not limited to these examples.

[Example 1] Synthesis of Composite comprising Iron Compound and Graphene Oxide

(1) Synthesis of Graphene Oxide

Concentrated sulfuric acid (95 to 98%, 133 cm$^3$) and graphite (Graphite flakes manufactured by Nacalai Tesque) (1.01 g) were added in a 500 cm$^3$ one-neck eggplant flask, and stirred at room temperature (about 20°C) for 15 minutes. Next, KMnO$_4$ (1.04 g) was added, and the mixture was stirred at room temperature (about 20°C) for about 1 day. Further, KMnO$_4$ (1.03 g) was added, and the mixture was stirred at room temperature (about 20°C) for about 1 day. Further, KMnO$_4$ (1.04 g) was added, and the mixture was stirred at room temperature (about 20°C) for about 1 day. Finally, KMnO$_4$ (1.03 g) was added, and the mixture was stirred at room temperature (about 20°C) for about 1 day to obtain a light purple suspension.

Next, ice (100 cm$^3$) was added in a beaker, and the light purple liquid was slowly poured into the beaker. Further, a 30% H$_2$O$_2$ aqueous solution was slowly added until the liquid turned to light green from light purple while the beaker was cooled in an ice bath. The resulting suspension was dispensed in small amounts into centrifuge tubes, and centrifugally separated (3900 rpm, 3 hours). The supernatant liquid was removed, and the sediment was washed with water, and then centrifugally separated (3900 rpm, 30 minutes). The supernatant liquid was removed, and the sediment was washed with a 5% HCl aqueous solution, and then centrifugally separated (3900 rpm, 30 minutes). Similarly, the supernatant liquid was removed, and the sediment was washed with ethanol, and then centrifugally separated (3900 rpm, 30 minutes). Further, the supernatant liquid was removed, and the sediment was washed with ethanol, and then centrifugally separated (3900 rpm, 30 minutes). Finally, the supernatant liquid was removed, and the sediment was washed with diethyl ether, then filtered, and dried under reduced pressure in a desiccator to obtain graphene oxide as a brown solid (yield: 1.797 g).

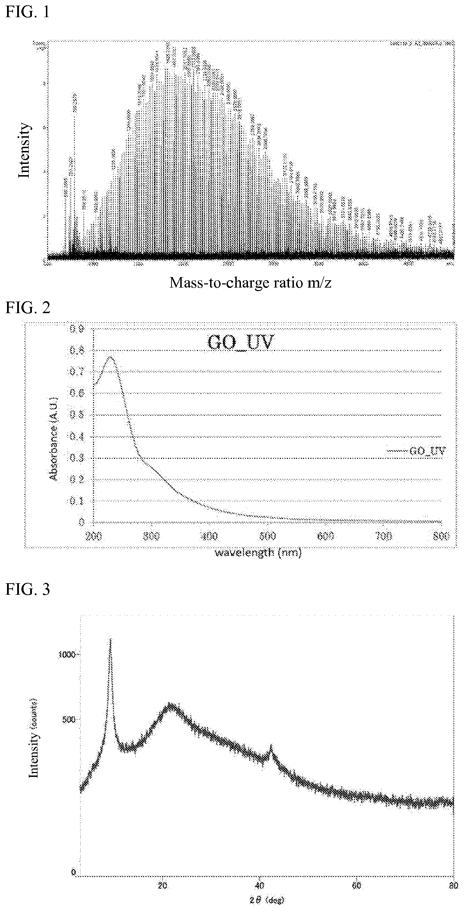

The resulting graphene oxide was subjected to matrix-assisted laser desorption/ionization (MALDI) and Fourier transform ion cyclotron resonance mass spectrometry (FT-ICR-MS analysis) using Solarix manufactured by Bruker Daltonics Inc. The results are shown in Fig. 1. From Fig. 1, it has been confirmed that the chemical species of the graphene oxide around the maximum peak (at a molecular weight of around 2000) is [C$_8$O$_4$H$_3$]$_{12.3}$

The ultraviolet and visible absorption spectrum (UV/VIS/NIR Spectrophotometer V-570 manufactured by JASCO Corporation) of the resulting graphene oxide is shown in Fig. 2, and the powder X-ray diffractometer (Desktop X-Ray Diffractometer MiniFlex 600 manufactured by Rigaku Corporation) is shown in Fig. 3.

(2) Synthesis of Composite of Iron Compound and Graphene Oxide

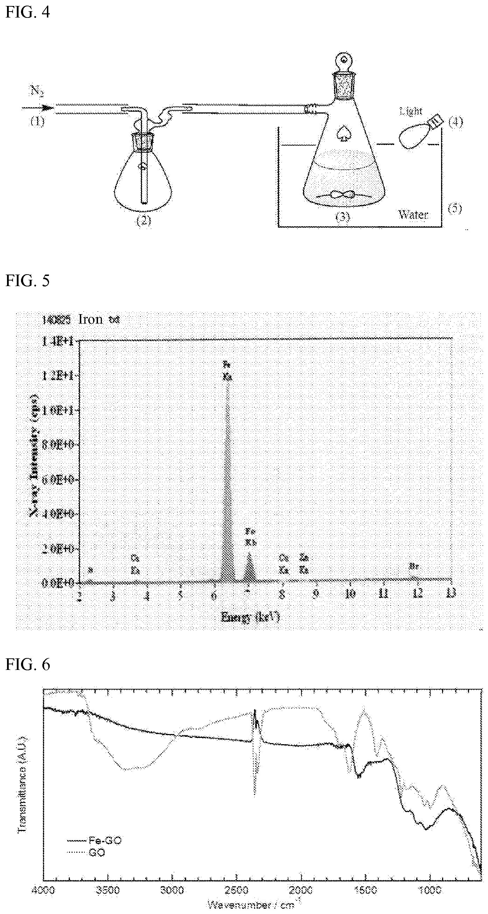

An equipment having a configuration as shown in Fig. 4 [equipment which includes a hard glass vessel (3) including a nitrogen supply line (1) with a bubbler, a reaction mixture back stopper (2), a stirrer, and an inert gas inlet and outlet and which includes a mercury lamp with a quartz jacket (USHIO 450W high-pressure mercury lamp: (4)) and a water bath with a circulation-type cooling system (30°C: (5)) at the outer part] was assembled, and the graphene oxide (0.182 g) obtained in (1) (Synthesis of Graphene Oxide) and Fe(CO)$_5$ (0.177 g) were mixed with tetrahydrofuran (THF, 20 cm$^3$, deoxidized). The graphene oxide was finely dispersed in the tetrahydrofuran. Next, the reaction mixture was irradiated at room temperature with light having a wavelength of 260 to 600 nm (1 hour and 30 minutes) using a mercury lamp (USHIO, UM-452). The reaction mixture turned to black from brown when irradiated with light. Next, under a nitrogen gas atmosphere, the resulting reaction mixture was filtered to obtain a black solid (the filtrate was light green). The black solid was washed with THF (10 cm$^3$), dichloromethane (10 cm$^3$) and ether (10 cm$^3$), and then vacuum-dried to obtain a composite comprising an iron compound and a graphene oxide (yield: 0.16 g).

At room temperature, a solid powder of the composite comprising iron compound and graphene oxide which was obtained by the reaction was put on a drug packing paper, and a magnet (Nd-Fe-B based magnet, manufactured by NIHON JISYAKU KOGYO CO., LTD., neodymium magnet, $\phi$10 mm x 2 mm) was applied from below the drug packing paper, but the composite did not stick to the drug packing paper.

The composite comprising iron compound and graphene oxide which was obtained by the reaction was dispersed in an acidic aqueous solution (pH 2) or a basic aqueous solution (pH 14) in a test tube, and irradiated with light (white LED: OSW4XME3C1E, Optosupply, 8 days) at room temperature, and a magnet was brought into contact with the outer wall of the test tube, but the composite was not attracted to the magnet to stick to the test tube wall.

For the composite comprising iron compound and graphene oxide which was obtained by the reaction, X-ray fluorescence analysis was performed using Desk-Top Total Reflection X-Ray Fluorescence Spectrometer NANOHUNTER manufactured by Rigaku Corporation. The results of the analysis are shown in Fig. 5. From the results of the X-ray fluorescence analysis, it was confirmed that the composite contained Fe.

For the composite comprising iron compound and graphene oxide which was obtained by the reaction, an infrared absorption spectrum (IR) was measured by ATR method using FT-IR Spectrometer FT/IR-6200 (manufactured by JASCO Corporation). The results of the measurement are shown in Fig. 6. Fe-GO denotes the composite comprising iron compound and graphene oxide in this Example, and GO denotes the graphene oxide in Example 1(1). Since the spectrum shown in Fig. 6 has no absorption around 2000 cm$^{-1}$ originating from a Fe-CO group, it is apparent that all COs in Fe(CO)$_5$ are eliminated. In the spectrum in Fig. 6, absorptions confirmed in the infrared absorption spectrum of graphene oxide as a raw material: a broad absorption at 3000 to 3800 cm$^{-1}$ and an absorption at 1382 cm$^{-1}$ originating from an O-H group, and an absorption at 1614 cm$^{-1}$ originating from a C=O group substantially disappeared (each of the relative ratios of peak heights of these absorptions to the peak height of the absorption originating from a C-O group is 0.1 or less), and an absorption at 1072 cm$^{-1}$ originating from a C-O group remained. From these results, it is apparent that in the composite, carboxyl groups and hydroxyl groups in graphene oxide as a raw material disappear, and epoxy groups remain. Further, an absorption at 701 cm$^{-1}$ originating from a Fe-O group is substantially absent (the relative value of its peak height of the absorption to the peak height of the absorption originating from a C-O group is 0.1 or less).

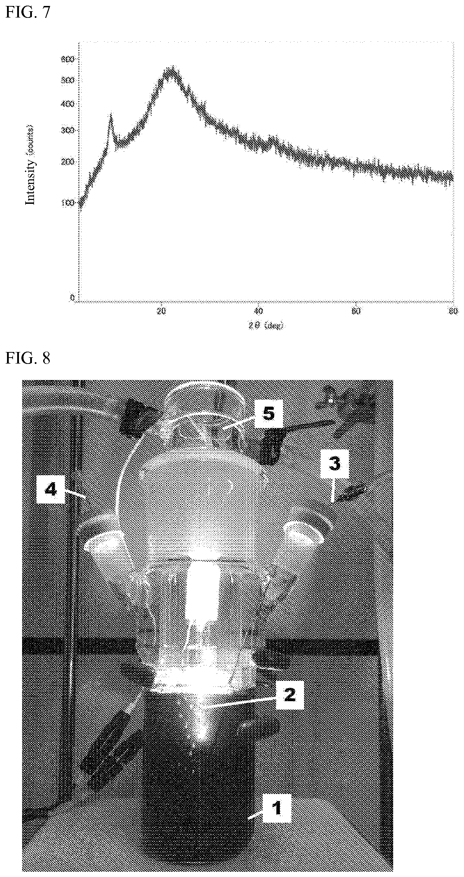

For the composite comprising iron compound and graphene oxide which was obtained by the reaction, powder X-ray diffraction measurement was performed using Desk-Top X-Ray Diffractometer MiniFlex 600 (manufactured by Rigaku Corporation). The results of the measurement are shown in Fig. 7. As shown in Fig. 7, it is apparent that there is a relatively sharp signal at $2\theta$=9.65°, and thus the interlayer structure of graphene oxide is partially maintained. In Fig. 7, a structural diffraction signal from iron does not appear. This shows that many of iron compound particles exist in graphene oxide as nanoparticles having a size of about 3 nm or less. Comparison between the powder X-ray diffraction measurements shows that graphene oxide in the composite comprising iron compound and graphene oxide turns more amorphous as a whole in comparison with graphene oxide used as a raw material.

Further, the content ratio of Fe in the composite comprising iron compound and graphene oxide which was obtained by the reaction was quantitatively determined by the following method.

Specifically, the composite (5.0 mg) of an iron compound and graphene oxide which was obtained by the reaction was added to royal water (4 cm$^3$, HCl : HNO$_3$ = 3 : 1), and the mixture was stirred at 50°C for 2 hours, and then stirred at room temperature (about 20°C) overnight. The resulting reaction solution was diluted by adding water thereto, and the supernatant liquid was then collected in a 100 cm$^3$ measuring flask using a centrifugal separator (3900 rpm, 10 minutes). An operation of washing the remaining sediment with water, centrifugally separating the sediment in the same manner as described above, and collecting the supernatant liquid was repeated total five times. Water was added to the collected supernatant liquid to obtain a 100 cm$^3$ preparation liquid. Using the preparation liquid, inductively coupled plasma mass spectrometry (ICP-MS) measurement (calibration curve method) was performed. The measurement results are shown in Table 1. In Table 1, samples 1/100 and 1/10 correspond to the results of performing measurement with the preparation liquid diluted with water by a factor of 100 and by a factor of 10, respectively. The content ratio of Fe in the 100 cm$^3$ preparation liquid was calculated by multiplying a solution concentration by a dilution ratio.

[Table 1]

| Sample | Specimen | Dissolution concentration (ppb) | Dilution ratio | Content ratio (ppm) |
|--------|----------|---------------------------------|----------------|---------------------|
| 1/100 | Fe56 | 34.6501 | 100.91 | 3.49 |

(continued)

| Sample | Specimen | Dissolution concentration (ppb) | Dilution ratio | Content ratio (ppm) |
|--------|----------|--------------------------------|----------------|---------------------|
| 1/100 | Fe57 | 34.9327 | 100.91 | 3.52 |
| 1/10 | Fe56 | 333.7690 | 10.05 | 3.35 |
| 1/10 | Fe57 | 332.4528 | 10.05 | 3.34 |

The above results show that the content of Fe in the composite of iron compound and graphene oxide is 3.425 [ppm(mg/kg)] $\times$ 0.1 (kg) = 0.343 mg per 100 $cm^3$ of the preparation liquid (i.e. the content of Fe in the composite comprising iron compound and graphene oxide is about 7% by mass).

[Example 2] Synthesis of Composite of Iron Compound and Graphene Oxide

The graphene oxide (4 mg) obtained in Example 1(1) was suspended in a 50% ethanol aqueous solution (20 $cm^3$). To the resulting suspension was added $Fe(CH_3COO)_2$ (10.9 mg), a photoreaction (1 hour) was then carried out in the similar manner to Example 1(2), and the similar washing treatment to Example 1(2) was performed to obtain a composite comprising an iron compound and a graphene oxide (yield: 4.2 mg).

[Example 3] Synthesis of Composite comprising Iron Compound and Graphene Oxide

In a reaction equipment in Fig. 8 (reaction equipment which includes a hard glass reaction vessel [1] including a stirrer, an inert gas inlet [3] and outlet [4], and a water-flow cooler as necessary and which includes a light irradiator [2] covered with a cooling jacket [5] of quartz glass, at the inner part), pentacarbonyl iron (manufactured by Kanto Chemical Co., Inc.; 0.5 g) was added to a suspension of the graphene oxide (0.5 g) in Example 1(1) and THF (100 $cm^3$) under an argon gas atmosphere, and the mixture was hermetically sealed, and then stirred at room temperature for 10 minutes. The mixture was irradiated with light at room temperature for 1 hour and 30 minutes using a 100 W high-pressure mercury lamp (wavelength: 180 nm to 600 nm, SEN LIGHTS Co., Ltd., HL100CH-4) while a nitrogen gas was bubbled under water-flow cooling. After the irradiation with light, the resulting mixture was filtered under an argon atmosphere, and washed with dehydrated THF and diethyl ether. The mixture was dried under reduced pressure in a desiccator to obtain 0.611 g of a composite as a black solid.

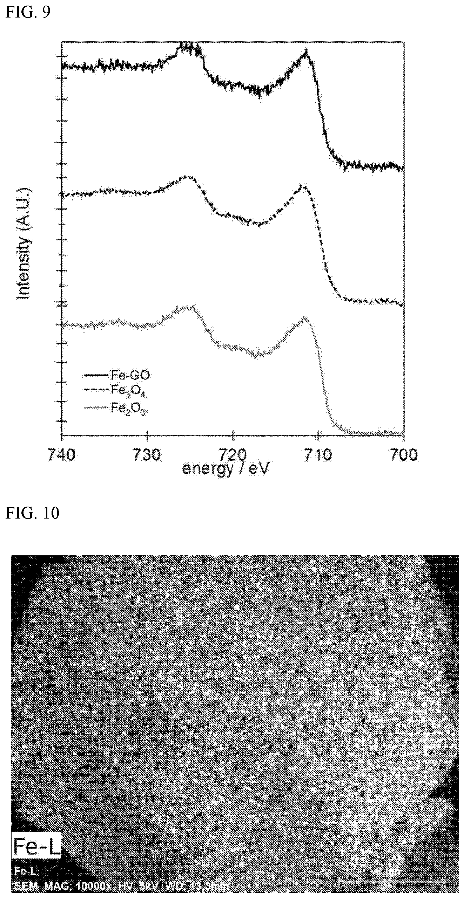

For the composite comprising iron compound and graphene oxide which was obtained by the reaction, X-ray photoelectron spectroscopy (XPS) was performed using B002431 manufactured by OMICRON, Ltd. (X-ray source Al-K$\alpha$:hv = 1486.6 eV, width = 0.85 eV, power: 250 W) [energy sweep interval: 0.1 eV, capture time: 0.2 sec and cumulative number: 15 under the reduced pressure condition of 5.0 x $10^{-7}$ Torr or lower]. The results of the resulting XPS spectrum are shown in Fig. 10. In Fig. 10, Fe-GO denotes a composite comprising an iron compound and a graphene oxide, $Fe_3O_4$ denotes triiron tetraoxide ($Fe_3O_4$) ($Fe_3O_4$ powder: Kishida Chemical Co., Ltd, Triiron Tetraoxide 020-40855, Lot. E41582F), and $Fe_2O_3$ denotes diiron trioxide ($Fe_2O_3$) ($Fe_2O_3$ powder: Mitsuwa Chemicals Co., Ltd, Iron(III) Oxide powder, ca.0.3$\mu$, No.64697). From Fig.10, it is apparent that the composite contains either one or both of $Fe_3O_4$ and $Fe_2O_3$.

Next, for the surface of the composite comprising iron compound and graphene oxide which was obtained by the reaction, observation of SEM images and mapping images of atoms and elemental analysis were performed using, respectively, Scanning Electron Microscope SU 6600 manufactured by Hitachi High-Technologies Corporation and an attached equipment (Bruker ASX QUANTAX XFlash 5060FQ: energy dispersive spectroscopy) manufactured by Bruker Corporation. In each case, measurement was performed with a sample attached to a carbon tape.

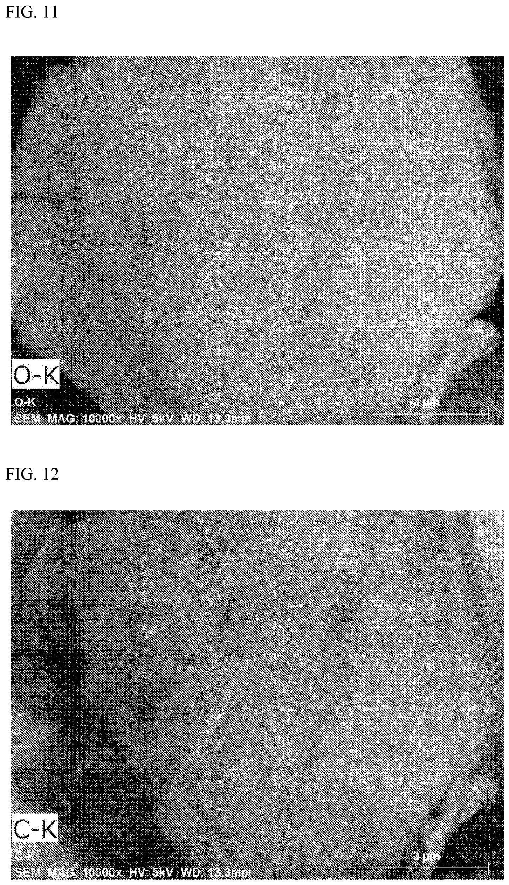

A mapping image of iron atoms is shown in Fig. 10 (a section displayed in white corresponds to an area where iron atoms exist), a mapping image of oxygen atoms is shown in Fig. 11 (a section displayed in white corresponds to an area where oxygen atoms exist), and a mapping image of carbon atoms is shown in Fig. 12 (a section displayed in white corresponds to an area where carbon atoms exist).

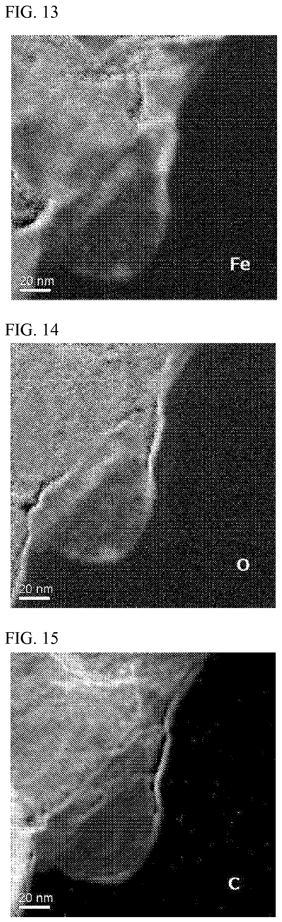

The resulting composite was observed by energy dispersive spectroscopy (TEM/EDX) using JEOL FEG Transmission Electron Microscope (300 kW) manufactured by JEOL Ltd. A mapping image of iron atoms is shown in Fig. 13 (a section displayed in white corresponds to an area where iron atoms exist), a mapping image of oxygen atoms is shown in Fig. 14 (a section displayed in white corresponds to an area where oxygen atoms exist), and a mapping image of carbon atoms is shown in Fig. 15 (a section displayed in white corresponds to an area where carbon atoms exist).

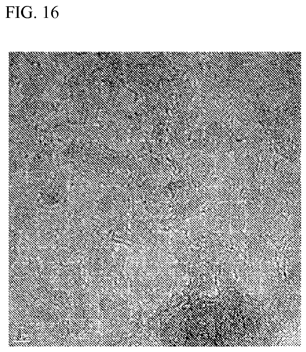

Further, a TEM image taken at a higher magnification ratio is shown in Fig. 16.

From Figs. 10 to 15, it is apparent that on the composite comprising iron compound and graphene oxide, iron atoms and oxygen atoms are dispersed and supported with high uniformity. From Fig. 16, it is apparent that many of iron compound particles existing in the composite comprising iron compound and graphene oxide have a size of about 3 nm or less.

Further, the results of elemental analysis of the composite which is measured by scanning electron microscopy/energy dispersive spectroscopy (SEM/EDX) are shown below.

C: 38.87 wt%; O: 34.47 wt%; Fe: 22.77 wt%; and S: 3.88 wt%.

Sulfur (S) is an impurity contained in graphene oxide.

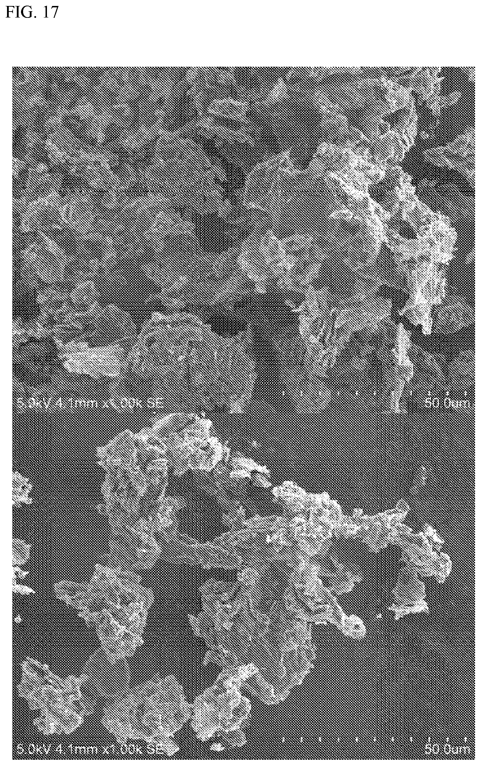

For the composite comprising iron compound and graphene oxide which was obtained by the reaction, two photographs taken using a scanning electron microscope (SU6600 manufactured by Hitachi High-Technologies Corporation.) are shown in Fig. 17. It is apparent that the composite comprising iron compound and graphene oxide form particles in which scale-like and/or plate-like primary particles are aggregated, and the diameter of the primary particles is 0.2 $\mu$m to 40 $\mu$m.

[Example 4] Synthesis of Composite comprising Iron Compound and Graphene Oxide

In the reaction equipment in Fig. 8, anhydrous iron acetate (manufactured by Aldrich Co.; 0.5 g) was added to a suspension of the graphene oxide (0.5 g) in Example 1(1) and an ethanol aqueous solution (100 mL, 50 vol%), and the mixture was stirred at room temperature for 10 minutes. The mixture was irradiated with light at room temperature for 1 hour and 30 minutes using a high-pressure mercury lamp (wavelength: 180 nm to 600 nm, HL100CH-4 manufactured by SEN LIGHTS Co., Ltd.) while a nitrogen gas was bubbled under water-flow cooling. After the irradiation with light, the resulting mixture was filtered, and washed with water and ethanol. The mixture was dried under reduced pressure in a desiccator to obtain 0.8 g of a composite as a black solid.

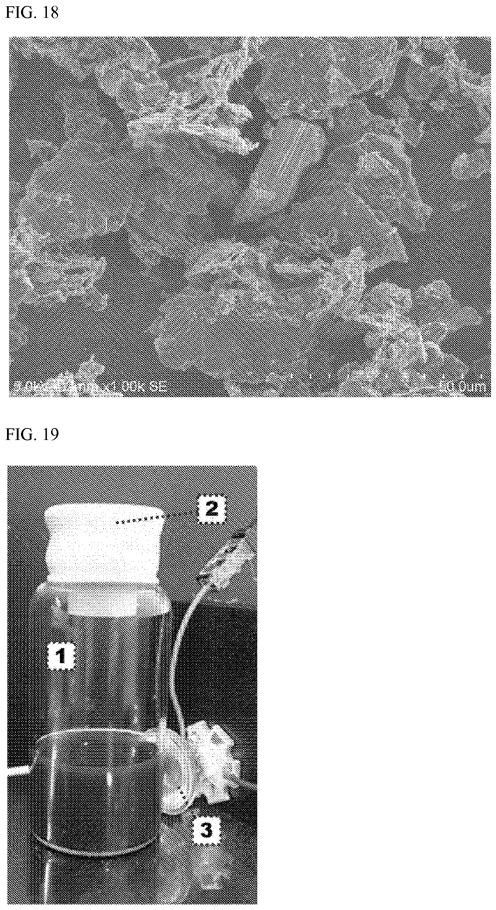

For the composite comprising iron compound and graphene oxide which was obtained by the reaction, a scanning electron microscope photograph is shown in Fig. 18. It is apparent that the composite comprising iron compound and graphene oxide form particles in which scale-like and/or plate-like primary particles are aggregated, and the diameter of the primary particles is in the range of 0.5 $\mu$m to 40 $\mu$m.

[Example 5] Production (Generation) of Hydrogen

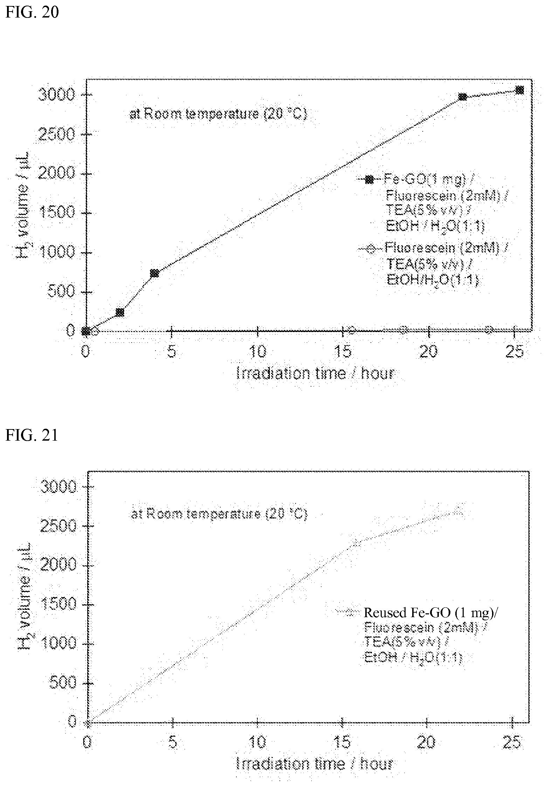

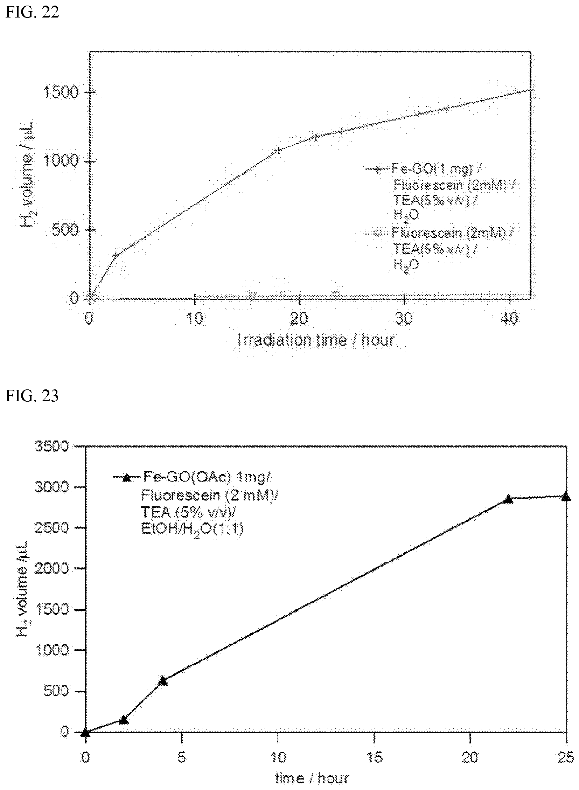

Hydrogen was produced (generated) from water and ethanol by a reaction equipment in Fig. 19 (a vial (30 cm$^3$: [1]) including a septum stopper [2] and a white LED (OSW4XME3CIE, Optosupply: [3]) using as a photocatalyst the composite comprising iron compound and graphene oxide which was obtained in Example 1(2). The composite (1 mg) comprising iron compound and graphene oxide in Example 1(2), fluorescein (6.6 mg), triethylamine (5% v/v), and ethanol and water (volume ratio of ethanol and water = 1 : 1) were mixed (mixture A1). The mixture A1 (10 cm$^3$) was added in a vial (30 cm$^3$), and the vial was capped with a septum stopper, and irradiated with white LED light (OSW4XME3CIE, Optosupply) at 20°C while the mixture was stirred by a stirrer. After the irradiation with light, 0.1 cm$^3$ of a gas in the space in the vial was sampled every fixed time period (up to 25 hours) using a gastight syringe, and the amount of hydrogen in the sampled gas was quantitatively determined by gas chromatography (equipment: GC-3200 manufactured by GL Science Inc., column: Molecular Sieve 13X 60/80 manufactured by GL Science Inc., outer diameter = 1/8 inches, inner diameter = 2.2 mm, length = 4 m, column temperature: 60°C, TCD temperature: 60°C, injector temperature: 60°C, carrier gas: nitrogen gas, TCD current: 60 mA, column pressure: 200 kPa). Since the volume of the space in the vial (volume of the vial except the volumes of the septum stopper and the solution) is 20 cm$^3$, a relationship between the light irradiation time and the total amount of generated hydrogen as determined in accordance with the following formula is shown in Fig. 20. In Fig. 20, Fe-GO denotes the composite comprising iron compound and graphene oxide, and TEA denotes triethylamine (the same applies in Figs. 21 and 22).

$$\text{(amount of hydrogen in sampled gas)} \times 200 \approx \text{(total amount of hydrogen generated from system)}$$

Fig. 20 also shows the results of carrying out a hydrogen production (generation) reaction using a mixture B1 prepared in the same manner as in the case of the mixture A1 except that a composite comprising an iron compound and a graphene oxide was not added for comparison. From the results in Fig. 20, it is apparent that when a composite comprising an iron compound and a graphene oxide was used, the hydrogen generation amount reached 3.0 cm$^3$ or more at about 25 hours, and when the composite was not used, the hydrogen generation amount was substantially 0 cm$^3$. This shows that the composite comprising iron compound and graphene oxide according to the present invention is extremely useful as a photocatalyst for producing (generating) hydrogen from water and ethanol.

[Example 6] Production (Generation) of Hydrogen

Except that after the hydrogen production (generation) reaction in Example 5, the composite comprising iron compound and graphene oxide was filtered, and washed with distilled water, and the resulting composite was used as a photocatalyst, the similar procedure to Example 5 was carried out to prepare a mixture A1, and a hydrogen production (generation) reaction was carried out in the similar manner to Example 5 using the mixture A1. A relationship between the light irradiation time and the total amount of generated hydrogen is shown in Fig. 21. These results show that the composite comprising iron compound and graphene oxide exhibited an excellent catalytic activity even when the once-used photocatalyst was reused after being filtered and washed.

[Example 7] Production (Generation) of Hydrogen

Except that only water was used in place of ethanol and water (volume ratio 1 : 1), the similar procedure to Example 5 was carried out to prepare a mixture A2, and a hydrogen production (generation) reaction was carried out in the similar manner to Example 5 using the mixture A2. A relationship between the light irradiation time and the total amount of generated hydrogen is shown in Fig. 22. Fig. 22 also shows the results of carrying out a hydrogen production (generation) reaction using a mixture B2 prepared in the similar manner to in the case of the mixture A2 except that a composite comprising an iron compound and a graphene oxide was not added for comparison. These results show that the composite comprising iron compound and graphene oxide according to the present invention is extremely useful as a photocatalyst for producing (generating) hydrogen from water.

[Example 8] Production (Generation) of Hydrogen

A hydrogen production (generation) reaction was carried out in the similar manner to Example 5 except that the composite comprising iron compound and graphene oxide in Example 4 was used as a photocatalyst. A relationship between the light irradiation time and the total amount of generated hydrogen is shown in Fig. 23. In Fig. 23, Fe-GO (OAc) denotes the composite comprising iron compound and graphene oxide which was obtained in Example 4, and TEA denotes triethylamine. These results show that the composite comprising iron compound and graphene oxide which is produced from $Fe(CH_3COO)_2$ is extremely useful as a photocatalyst for producing (generating) hydrogen from water.

[Example 9] Catalytic Ability of Electrode

(1) Preparation of Electrode

The composite comprising iron compound and graphene oxide which was obtained in Example 3, and a carbon paste (CPO Carbon Paste Oil Base manufactured by BAS Company) were mixed at a weight ratio of 1: 100, the mixture was packed into a recess of a carbon paste electrode (2210 manufactured by BAS Company), and the electrode was rubbed against a drug packing paper placed on a flat stand, thereby obtaining an electrode.

(2) Catalytic Ability of Electrode

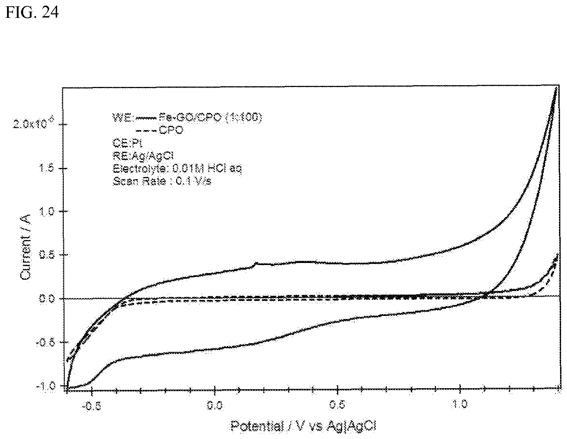

The electrode in (1) (Production of Electrode) was used as a working electrode, a platinum line was used as a counter electrode, and a silver/silver chloride electrode was used as a reference electrode. As a supporting electrolyte solution, a 0.01 M HCl aqueous solution was used. The above-mentioned three electrodes were inserted in a supporting electrolyte solution ($3 cm^3$) in a cylindrical glass cell (inner diameter: 16 mm), a nitrogen gas was bubbled into the cell to remove dissolved oxygen in the test solution, and cyclic voltammetry measurement was then performed. As a potentiostat, an electrochemical analyzer (BAS, model 608A) was used. The results of the measurement are shown in Fig. 24. In Fig. 24, Fe-GO denotes the composite comprising iron compound and graphene oxide, and CPO denotes the carbon paste. These results show that a current generated by proton reduction is observed on a lower potential side as compared to an electrode with only a CPO, and thus an electrode containing as an active component the composite comprising iron compound and graphene oxide according to the present invention has a catalytic ability.

**Claims**

1. A particulate composite comprising an iron compound and a graphene oxide, wherein

   (1) the particle size of primary particles in the particulate composite is in the range of 0.1 to 100 $\mu$m,

(2) the particle size of the iron compound is in the range of 0.1 to 10 nm,

(3) the content of iron to the composite is in the range of 0.1 to 50% by mass,

(4) an absorption originating from an O-H group, an absorption originating from a C=O group, and an absorption around 701 cm$^{-1}$ originating from a Fe-O group are substantially absent, and an absorption originating from a C-O group is present, in an infrared absorption spectrum, and

(5) the iron compound is supported on the graphene oxide.

2.  The composite according to claim 1, wherein the iron compound is $Fe_3O_4$, $Fe_2O_3$ or a mixture thereof.

3.  The composite according to claim 1 or 2, wherein the particle size of the iron compound is in the range of 0.5 to 5 nm.

4.  The composite according to any one of claims 1 to 3, wherein the content of iron to the composite is in the range of 0.5 to 40% by mass.

5.  The composite according to any one of claims 1 to 4, wherein there is substantially no signal above $2\theta = 30°$ in powder X-Ray diffraction measurement.

6.  The composite according to any one of claims 1 to 4, wherein the graphene oxide keeps supporting the iron compound after irradiation with white light in an aqueous solution at pH 2, and the graphene keeps supporting the iron compound after irradiation with white light in an aqueous solution at pH 14.

7.  A method for producing a composite comprising an iron compound and a graphene oxide, the method comprising the step of suspending an iron compound and a graphene oxide as raw materials in an inert solvent, and irradiating the resultant suspension with a light including ultraviolet and visible lights.

8.  The method according to claim 7, wherein the iron compound as a raw material is at least one of a salt of iron and an inorganic acid, a salt of iron and carboxylic acid, a salt of iron and sulfonic acid, iron hydroxide, phenol iron, an iron double salts, and an iron complex.

9.  The method according to claim 7 or 8, wherein the light including ultraviolet and the visible lights have a wavelength in the range of 100 nm to 800 nm.

10. The method according to any one of claims 7 to 9, wherein the time of irradiation with the light including ultraviolet and visible lights is in the range of 1 minute to 24 hours.

11. A photocatalyst including the composite comprising iron compound and graphene oxide according to any one of claims 1 to 6.

12. A method for producing hydrogen, the method comprising mixing water and/or an alcohol, and a photosensitizer and/or an electron donor as necessary in the presence of the composite comprising iron compound and graphene oxide according to any one of claims 1 to 6, and irradiating the mixture with light.

13. The method according to claim 12, wherein the alcohol is ethanol.

14. The method according to claim 12 or 13, wherein the light is sunlight or white LED light.

15. A hydrogen production equipment comprising the composite comprising iron compound and graphene oxide according to any one of claims 1 to 6 as a hydrogen generation catalyst.

FIG. 1

Mass-to-charge ratio m/z

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

## INTERNATIONAL SEARCH REPORT

| | International application No. |
|---|---|
| | PCT/JP2016/059776 |

| A. CLASSIFICATION OF SUBJECT MATTER |
|---|
| $C01B31/02$(2006.01)i, $B01J23/745$(2006.01)i, $B01J35/02$(2006.01)i, $B01J37/34$ (2006.01)i, $C01B3/04$(2006.01)i |

According to International Patent Classification (IPC) or to both national classification and IPC

| B. FIELDS SEARCHED |
|---|
| Minimum documentation searched (classification system followed by classification symbols) |
| C01B31/02, B01J23/745, B01J35/02, B01J37/34, C01B3/04 |

| Documentation searched other than minimum documentation to the extent that such documents are included in the fields searched |
|---|
| Jitsuyo Shinan Koho        1922–1996   Jitsuyo Shinan Toroku Koho   1996–2016 |
| Kokai Jitsuyo Shinan Koho  1971–2016   Toroku Jitsuyo Shinan Koho   1994–2016 |

| Electronic data base consulted during the international search (name of data base and, where practicable, search terms used) |
|---|
| JSTPlus/JST7580/JSTChina(JDreamIII) |

### C. DOCUMENTS CONSIDERED TO BE RELEVANT

| Category* | Citation of document, with indication, where appropriate, of the relevant passages | Relevant to claim No. |
|---|---|---|
| Y<br>A | Jae Young KIM et.al., Graphene-carbon nanotube composite as an effective conducting scaffold to enhance the photoelectrochemical water oxidation activity of a hematite film, RSC Advances, 2, The Royal Socirty of Chemistry, 2012.08.08, 9415-9422 | 1-4,11-15<br>5-10 |
| Y | JP 2013-35743 A (Institute of National Colleges of Technology), 21 February 2013 (21.02.2013), claims 1, 2; paragraphs [0016], [0019], [0061] (Family: none) | 1-4,11-15 |
| Y | Guancai XIE et.al., Graphene-based materials for hydrogen generation from light-driven water splitting, Advanced Materials, 2013.07.26, 25, 3820-3839 | 1-4,11-15 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 May 2016 (20.05.16) | 07 June 2016 (07.06.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (January 2015)

**INTERNATIONAL SEARCH REPORT**

International application No.

PCT/JP2016/059776

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2012-245469 A  (Toyota Industries Corp.), 13 December 2012 (13.12.2012), paragraph [0009] (Family: none) | 13-15 |

Form PCT/ISA/210 (continuation of second sheet) (January 2015)

**EP 3 275 836 A1**

## REFERENCES CITED IN THE DESCRIPTION

**Patent documents cited in the description**

- JP 2012245469 A
- JP 2013035743 A
- JP 2014069973 A

**Non-patent literature cited in the description**

- *Chemical Society of Japan, Lecture Proceedings,* 2015, vol. 95 (3), 649
- *Nanoscale Research Letters,* 2014, vol. 9, 656
- *Advanced Materials,* 2013, vol. 25, 3820-3839